Europäisches Patentamt

European Patent Office

Office européen des brevets

(11) Veröffentlichungsnummer: **0 255 927**
**A2**

## (12) EUROPÄISCHE PATENTANMELDUNG

(21) Anmeldenummer: 87111167.0

(22) Anmeldetag: 03.08.87

(51) Int. Cl.⁴: **H03G 3/20** , H03J 5/24

(30) Priorität: 06.08.86 DE 3626575

(43) Veröffentlichungstag der Anmeldung:
**17.02.88 Patentblatt 88/07**

(84) Benannte Vertragsstaaten:
**DE FR GB IT NL**

(71) Anmelder: **TELEFUNKEN electronic GmbH**
**Theresienstrasse 2**
**D-7100 Heilbronn(DE)**

(72) Erfinder: **Reuschle, Roland, Dipl.-Ing. (FH)**
**Hauffweg 4**
**D-7125 Kirchheim/N(DE)**

(74) Vertreter: **Maute, Hans-Jürgen, Dipl.-Ing.**
**TELEFUNKEN electronic GmbH**
**Theresienstrasse 2**
**D-7100 Heilbronn(DE)**

(54) **Umschaltbarer Tunervorverstärker.**

(57) Bei einem umschaltbaren Tunervorverstärker mit einer Feldeffekt-Tetrode aus einem Verbindungshalbleiter, deren einer Gateelektrode das Hochfrequenz-Eingangssignal und deren anderer Gateelektrode das Regelsignal zur Regelung des Hochfrequenz-Eingangssignals zugeführt wird, ist ein Bauelement mit Diodencharakteristik vorgesehen, welches bei Bandumschaltung und angelegter Regelspannung einen unerwünschten Stromfluß an der zur Regelung des Hochfrequenz-Eingangssignals vorgesehenen Gateelektrode verhindert.

FIG.3

# Umschaltbarer Tunervorverstärker

Die Erfindung betrifft einen umschaltbaren Tunervorverstärker mit einer Feldeffekt-Tetrode aus einem Verbindungshalbleiter, deren einer Gateelektrode das Hochfrequenz-Eingangssignal und deren anderer Gateelektrode das Regelsignal zur Regelung des Hochfrequenz-Eingangssignals zugeführt wird, bei dem die Bandumschaltung durch Abschalten der Drain-Spannungsversorgung erfolgt.

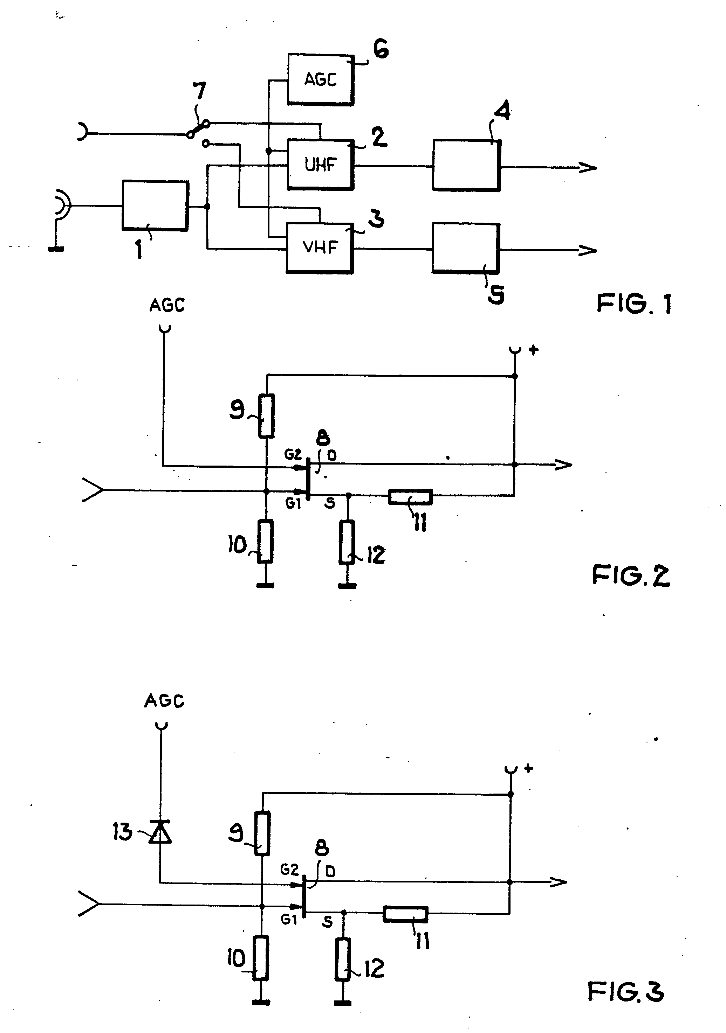

Ein derartiger Tunervorverstärker findet beispielsweise in einem Fernsehtuner Anwendung. Die Figur 1 zeigt das Prinzipschaltbild (Blockschaltbild) eines Fernsehtuners. Nach der Figur 1 wird bei einem Fernsehtuner das Antennensignal einem Anpaßnetzwerk 1 zugeführt. Das Ausgangssignal des Anpaßnetzwerkes 1 wird den beiden Vorverstärkern zugeführt, d.h. also der UHF-Stufe 2 und der VHF-Stufe 3. Der UHF-Stufe 2 ist das Bandfilter 4 und der VHF-Stufe 3 ist das Bandfilter 5 nachgeschaltet. Die UHF-Stufe 2 und die VHF-Stufe 3 erhalten außer dem HF-Signal noch ein weiteres Signal, und zwar das sogenannte AGC-Signal von der AGC-Stufe 6. Das AGC-Singal hat die Aufgabe, das Hochfrequenz-Eingangssignal zu regeln (schwächen). Der Begriff "AGC" ist eine Abkürzung für "Automatic Gain Control". Die AGC-Stufe ist beispielsweise ein ZF-IC. ZF bedeutet Zwischenfrequenz. Der Bandumschalter 7 hat die Aufgabe, die Betriebsspannung entweder der UHF-Stufe 2 oder der VHF-Stufe 3 zuzuführen.

Ein Vorverstärker wie z.B. eine UHF-Stufe oder VHF-Stufe besteht gemäß der Figur 2 beispielsweise aus einer Feldeffekt-Tetrode 8 mit Drain und Source sowie den Gateelektroden G1 und G2. Umschaltbare Tunervorverstärker verwenden heute z.T. Feldeffekt-Tetroden, deren Halbleiterkörper aus einem Verbindungshalbleiter wie Gallium-Arsenid besteht. Feldeffekt-Tetroden aus einem Verbindungshalbleiter haben bei Verwendung in einem Vorverstärker z.B. folgende Vorteile: größere Leistungsverstärkung, weniger Rauschen, mehr Selektivität, besseres Großsignalverhalten.

Die Widerstände 9 und 10 bilden bei dem Vorverstärker der Figur 2 einen Spannungsteiler zur Einstellung des Arbeitspunktes an der Gateelektrode G1 der Feldeffekt-Tetrode 8. Die Drainelektrode der Feldeffekt-Tetrode 8 ist direkt mit der Betriebsspannung verbunden, während für die Einstellung der Vorspannung an der Sourceelektrode die Widerstände 11 und 12 dienen.

Bei Verwendung der Vorverstärkerstufe der Figur 2 in einem Fernsehtuner z.B. erfolgt eine Bandabschaltung bzw. Bandumschaltung. Dabei wird die Drain-Spannungsversorgung an der Feldeffekt-Tetrode abgeschaltet. Der Erfindung liegt die Erkenntnis zugrunde, daß die Bandabschaltung bzw. Bandumschaltung bei einem Vorverstärker der Figur 2 zur einer Zerstörung der Feldeffekt-Tetrode führen kann. Die Aufgabe der Erfindung besteht darin, einen umschaltbaren Vorverstärker der eingangs erwähnten Art anzugeben, bei dem die Gefahr der Zerstörung der Feldeffekt-Tetrode nicht auftritt. Diese Aufgabe wird bei einem umschaltbaren Tunerverstärker der eingangs erwähnten Art nach der Erfindung dadurch gelöst, daß ein Bauelement mit Diodencharakteristik vorgesehen ist, welches bei Bandumschaltung bzw. Bandab schaltung und angelegter Regelspannung einen unerwünschten Stromfluß an der zur Regelung des Hochfrequenz-Eingangssignals vorgesehenen Gateelektrode verhindert.

Der Erfindung liegt die Erkenntnis zugrunde, daß bei Bandab-bzw. -umschaltung durch das Abschalten der Drainspannungsversorgung kein Potential mehr am Drain der Feldeffekt-Tetrode existiert und daß dadurch bei angelegter AGC die Schottky-Diode, die durch die zur Regelung vorgesehene Gateelektrode und den Halbleiterkörper gebildet wird, in Flußrichtung zu leiten beginnt. Dadurch entsteht ein unerwünschter Strom, der die Feldeffekt-Tetrode zerstören kann. Dieser Effekt wird erfindungsgemäß durch ein Bauelement mit Diodencharakteristik verhindert.

Die Erfindung wird im folgenden an einem Ausführungsbeispiel erläutert.

Die Figur 3 zeigt eine Vorverstärkerstufe (z.B. VHF, UHF) nach der Erfindung. Die Vorverstärkerstufe der Figur 3 unterscheidet sich von der Vorverstärkerstufe der Figur 2 dadurch, daß erfindungsgemäß der Gateelektrode G2 der Feldeffekt-Tetrode 8 eine Diode 13 vorgeschaltet ist. Die Diode verhindert wie jedes andere Bauelement mit Diodencharakteristik einen Stromfluß bei abgeschalteter Stufe und damit eine Strombelastung der hochohmigen AGC-Spannungsquelle (z.B. ZF-IC). Im aktiven Zustand der Verstärkerstufe fließt ein geringer Reststrom der Feldeffekt-Tetrode in umgekehrter Richtung, der einen geringen Spannungsabfall am Bauelement mit Dioden-Charakteristik verursacht. Es gibt somit keine negativen Einflüsse auf das Regelverhalten der Feldeffekt-Tetrode.

## Ansprüche

1) Umschaltbarer Tunervorverstärker mit einer Feldeffekt-Tetrode aus einem Verbindungshalbleiter, deren einer Gateelektrode das Hochfrequenz-Eingangssignal und deren anderer Gateelektrode das Regelsignal zur Regelung des Hochfrequenz-Eingangssignals zugeführt wird, bei dem die Bandumschaltung durch Abschalten der Drain-Spannungsversorgung erfolgt, dadurch gekennzeichnet, daß ein Bauelement mit Diodencharakteristik vorgesehen ist, welches bei Bandumschaltung und angelegter Regelspannung einen unerwünschten Stromfluß an der zur Regelung des Hochfrequenz-Eingangssignals vorgesehenen Gateelektrode verhindert.

2) Tunervorverstärker nach Anspruch 1, dadurch gekennzeichnet, daß das Bauelement mit Diodencharakteristik derjenigen Gateelektrode vorgeschaltet ist, der das Regelsignal zugeführt wird.

3) Tunervorverstärker nach Anspruch 1 oder 2, dadurch gekennzeichnet, daß die Feldeffekt-Tetrode eine Tetrode mit Metall-Halbleiter-Gateelektrode ist.

4) Tunervorverstärker nach Anspruch 3, dadurch gekennzeichnet, daß die Tetrode ein Dual-Gate-n-Kanal-Feldeffekttransistor ist.

5) Tunervorverstärker nach einem der Ansprüche 1 bis 4, dadurch gekennzeichnet, daß als Bauelement mit Dioden-Charakteristik eine Diode, eine Zenerdiode, eine Leuchtdiode oder ein Transistor vorgesehen ist.

FIG. 1

FIG.2

FIG.3